# EUROPÄISCHE PATENTSCHRIFT

(11) **EP 1 229 339 B1**
(45) Veröffentlichungstag und Bekanntmachung des Hinweises auf die Patenterteilung: **01.12.2010**
(21) Anmeldenummer: 02000649.0
(22) Anmeldetag: 11.01.2002
(51) Int. Cl.: G01R 31/36, H01M 10/44

(54) **Verfahren zur Überwachung der Betriebssicherheit von wiederaufladbaren Li-Zellen**
Method of monitoring the safe operation of rechargeable lithium cells
Méthode de surveillance du fonctionnement fiable de piles rechargeables au lithium

(30) Priorität: 03.02.2001 DE 10104981
(43) Veröffentlichungstag der Anmeldung: 07.08.2002
(73) Patentinhaber: VARTA Microbattery GmbH, 30419 Hannover (DE)
(72) Erfinder: Hald, Rainer, 73479 Ellwangen (DE); Birke, Peter, Dr., 73479 Ellwangen (DE); Holl, Konrad, Dr., 73434 Aalen-Dewangen (DE); Ilic, Dejan, Dr., 73479 Ellwangen (DE)
(74) Vertreter: Patentanwälte Ruff, Wilhelm, Beier, Dauster & Partner

(56) Entgegenhaltungen:
- WO-A2-2005/060024
- US-A- 5 646 508
- US-A- 5 646 508
- US-A- 5 853 908
- PATENT ABSTRACTS OF JAPAN vol. 2000, no. 16, 8. Mai 2001 (2001-05-08) & JP 2001 025173 A (DENSO CORP), 26. Januar 2001 (2001-01-26)
- PATENT ABSTRACTS OF JAPAN vol. 1998, no. 06, 30. April 1998 (1998-04-30) & JP 10 056742 A (MATSUSHITA ELECTRIC IND CO LTD), 24. Februar 1998 (1998-02-24)
- PATENT ABSTRACTS OF JAPAN vol. 1999, no. 07, 31. März 1999 (1999-03-31) & JP 09 233713 A (INTERNATL BUSINESS MACH CORP <IBM>;AT BATTERY:KK; TOSHIBA BATTER), 5. September 1997 (1997-09-05)
- PATENT ABSTRACTS OF JAPAN vol. 2000, no. 09, 13. Oktober 2000 (2000-10-13) & JP 2000 166115 A (YANG TAI-HER), 16. Juni 2000 (2000-06-16)

## Beschreibung

Gegenstand der Erfindung ist ein Verfahren zur Überwachung der Betriebssicherheit von wiederaufladbaren Li-Zellen durch Messung und Kontrolle der Zellenspannung und der Zellentemperatur.

Wiederaufladbare Lithium/lon-Zellen erfordern eine spezielle Ladetechnik, insbesondere müssen vorgegebene Abschaltspannungen exakt eingehalten werden und, falls das Ladegerät versagt, muss eine Schutzschaltung die weitere Ladung unterbinden und sperren. Auch beim Entladen solcher Zellen dürfen bestimmte Spannungsuntergrenzen nicht unterschritten werden, um irreversible Schädigungen der Zelle zu vermeiden. Li-lon-Zellen sind daher mit speziellen elektronischen Schutzschaltern versehen, die bei Fehlverhalten des Laders oder des Geräts bei vorgegebenen Lade- und Entladeschlussspannungen abschalten und zusammen mit speziellen Sicherungen die Zelle vor unzulässigen Spannungsniveaus bzw. Strömen schützen und gefährliche Zustände, die irreversible Elektrolytzersetzungen und Zellschädigungen zur Folge haben könnten, verhindern sollen. Ladegeräte mit derartigen Überwachungsfunktionen sind beispielsweise in der WO 96/15563 beschrieben.

In der US 5,853,908 wird ein Verfahren beschrieben, gemäß dem zwischen nur kurzfristig auftretenden und länger anhaltenden Spannungsüberschreitungen unterschieden wird. Sobald eine Spannungsüberschreitung festgestellt wird, wird ein wärmeerzeugender Widerstand zugeschaltet, der wiederum mit einer thermischen Sicherung gekoppelt ist, die den Ladestrom unterbrechen kann. Dabei hat der Widerstand eine ausreichende Wärmekapazität, um das Ansprechen der thermischen Sicherung für einen kurzen Zeitraum (10 bis 30 Sekunden) zu verzögern. Die thermische Sicherung wird somit nur dann ausgelöst, wenn über diesen kurzen Zeitraum hinaus eine Überspannung vorliegt. Sofern dies jedoch der Fall ist, so kann über einen Transistor ein Entladewiderstand zugeschaltet werden, über den die Batterie entladen werden kann.

Der Erfindung liegt die Aufgabe zugrunde, ein Verfahren anzugeben, durch welches die Betriebssicherheit von wiederaufladbaren Li-Zellen weiter verbessert wird.

Diese Aufgabe wird erfindungsgemäß beim eingangs genannten Verfahren durch die kennzeichnenden Merkmale des Anspruchs 1 gelöst. In den Unteransprüchen sind weitere Ausgestaltungen des Verfahrens sowie eine zur Durchführung des Verfahrens geeignete Schaltungsanordnung angegeben.

Durch das erfindungsgemäße Verfahren wird die Li-Zelle vor elektrochemischer Zersetzung bei hoher Temperatur und kritischem Ladezustand geschützt, indem die Zelle soweit entladen wird, dass noch genügend Kapazität zur Verfügung steht, die Zelle sich aber nicht mehr in einem kritischen Ladezustand oder bei einer kritischen Temperatur befindet.

Im Folgenden ist der Gegenstand der Erfindung anhand der Figuren näher erläutert.

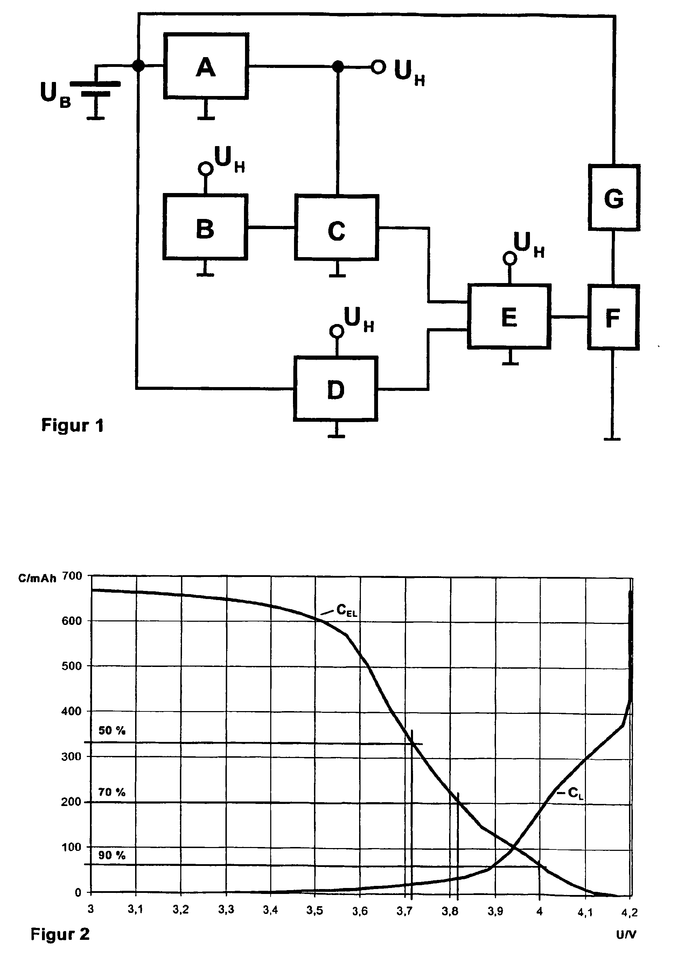

Figur 1 zeigt dabei das Prinzipschaltbild einer zur Durchführung des Verfahrens geeigneten Schaltungsanordnung. Figur 2 zeigt den Verlauf der Zellenkapazität in Abhängigkeit von der Zellenspannung bei Ladung C_{L} und bei Entladung C_{EL} bei einem Lade/Entladezyklus, der mit einem Strom von C/2 erfolgt.

Aus der Batteriespannung U_{B} wird im Schaltungsbaustein A eine Hilfsspannung U_{H} erzeugt, die zur Sicherstellung einer korrekten Funktionsweise der Schwellwertschalter und Logikgatter der Gesamtschaltung benötigt wird. Die stabile Hilfsspannung U_{H} ist vorzugsweise deutlich kleiner als die geringste Batteriespannung. Die Batteriespannung liegt bei den hier betrachteten Li-Zellen zwischen 2,7 und 4,2 Volt, so dass die stabile Hilfsspannung beispielsweise bei ca. 2,5 Volt liegen kann.

Ein Temperatursensor B erzeugt ein der Umgebungstemperatur proportionales Spannungssignal, welches einem Schwellwertschalter C zugeführt wird. Bei Überschreiten einer vorgegebenen oberen Grenztemperatur T_{G} schaltet der Schwellwertschalter C in den Ein-Zustand. Dieser Schwellwertschalter ist mit einer Hysterese konfiguriert. Er schaltet erst bei Unterschreitung einer deutlich unter der Grenztemperatur T_{G} liegenden neuen Temperatur in den Aus-Zustand zurück. Ein weiterer Schwellwertschalter D wird dann in den Ein-Zustand geschaltet, wenn die Batteriespannung einen vorgegebenen oberen Grenzwert U_{G} erreicht. Auch dieser Schwellwertschalter ist mit Hysterese konfiguriert, so dass er erst dann in den Aus-Zustand zurückschaltet, wenn ein deutlicher Abstand zwischen der vorher erreichten Grenzspannung U_{G} und der sich danach einstellenden Spannung erreicht wird. Die Ausgangssignale der beiden Schwellwertschalter C und D werden einem Logikgatter zugeführt, über welches mittels Schalter F der Lastwiderstand G dann an die Batterie angeschaltet wird, wenn sowohl die Temperatur als auch die Spannung die vorgegebenen Grenzwerte erreichen. Dieser Entladevorgang wird dann unterbrochen, wenn entweder die Zellenspannung deutlich unter die Grenzspannung U_{G} des Schwellwertschalters D gefallen ist, oder die Umgebungstemperatur ist unter die untere Schaltschwelle des Schwellwertschalters C gefallen. Als obere Grenzspannung wird vorzugsweise eine Spannung von ca. 4 Volt gewählt. Dies entspricht einem Ladezustand der Zelle von 90%, und die obere Grenztemperatur T_{G} wird mit 80° festgelegt. Die Entladung der Zelle, die bei Überschreiten beider Grenzwerte erfolgt, sollte bis zu einer Spannung von ca. 3,82 Volt, d.h. bis zu einem Ladezustand von 70% geführt werden. Es kann aber auch ausreichend sein, die Entladung nur bis zu einer Spannung von ca. 3,9 Volt absinken zu lassen, und als unteren Grenzwert für die Temperatur 70°C oder 60°C zu wählen.

Die Spannungs- und Temperaturgrenzwerte sind spezifisch für jedes System zu bestimmen und festzulegen. Für die Festlegung des unteren Spannungswertes gilt, dass die untere Grenzspannung so gewählt wird, dass bei Ende der Entladung die Spannung sich nicht wieder über den oberen Grenzwert erholt und so die Schaltung in Schwingung versetzen könnte.

Dank der Konfiguration der Schwellwertschalter mit Hysterese wird eine Schwingneigung weitgehend unterbunden. Die Funktionen der beschriebenen Prinzipschaltung lassen sich in die bekannten IC-Schaltungen, die zur Überwachung des Betriebes von wiederaufladbaren Li-Zellen dienen, inkorporieren.

Die erfindungsgemäßen Maßnahmen ermöglichen einen Schutz von wiederaufladbaren Li-Zellen, insbesondere auch Li-Polymer-Zellen, vor mechanischer und elektrochemischer Beschädigung bei hohen Temperaturen, durch Ladezustände, bei denen aufgrund der Höhe der Zellenspannung und der Höhe der Umgebungstemperatur elektrochemische Seitenreaktionen auftreten können, die sich in Erhöhung des Innenwiderstands und Kapazitätsverlusten äußern.

## Patentansprüche

1. Verfahren zur Überwachung der Betriebssicherheit einer wiederaufladbaren Li-Zelle durch Messung von Zellenspannung und Zellentemperatur, **dadurch gekennzeichnet, dass** ausschließlich bei gleichzeitigem Überschreiten einer vorgegebenen Zellengrenzspannung (U_{G}) und einer vorgegebenen Umgebungsgrenztemperatur (T_{G}) eine Entladung der Zelle erfolgt, bis ein vorgegebener unterer Spannungspegel oder eine vorgegebene untere Umgebungstemperatur erreicht ist.

2. Verfahren nach Anspruch 1, **dadurch gekennzeichnet, dass** die Grenzspannung (U_{G}) bei 4,0 Volt und die Grenztemperatur (T_{G}) bei ca. 80 °C liegt.

3. Verfahren nach den Ansprüchen 1 und 2, **dadurch gekennzeichnet, dass** der untere Spannungspegel niedriger als 3,9 Volt liegt und die untere Grenze der Umgebungstemperatur bei 70 °C liegt.

4. Verfahren nach den Ansprüchen 1 und 2, **dadurch gekennzeichnet, dass** die untere Grenzspannung bei 3,82 Volt und die untere Grenztemperatur bei 60 °C liegt.

5. Schaltungsanordnung zur Durchführung des Verfahrens nach einem der Ansprüche 1 bis 4, **dadurch gekennzeichnet, dass** sie einen ersten Schwellwertschalter (D) besitzt, der bei Überschreiten einer vorgegebenen oberen Grenzspannung (U_{G}) der Zelle anspricht und einen zweiten Schwellwertschalter (C), der bei Überschreiten einer vorgegebenen Grenze (T_{G}) der Umgebungstemperatur anspricht sowie eine Logikschaltung (E), die ausschließlich gleichzeitigem Ansprechen des ersten und zweiten Schwellwertschalters die Zelle an eine Last anschließt (G) und dass beide Schwellwertschalter (C, D) so konfiguriert sind, dass sie abfallen, wenn eine untere Zellenspannung oder eine untere Umgebungstemperatur erreicht ist.

## Claims

1. A method for monitoring the safe operation of rechargeable lithium cells by measuring cell voltage and cell temperature, **characterized in that** the cell is discharged exclusively if a predetermined cell limit voltage (U_{G}) and a predetermined ambient limit temperature (T_{G}) are exceeded at the same time, until a predetermined lower voltage level or a predetermined lower ambient temperature is reached.

2. The method according to claim 1, **characterized in that** the limit voltage (U_{G}) is 4.0 volts and the limit temperature (T_{G}) is approximately 80 °C.

3. The method according to claim 1 or 2, **characterized in that** the lower voltage level is less than 3.9 volts and the lower limit of the ambient temperature is 70 °C.

4. The method according to claim 1 or 2, **characterized in that** the lower limit voltage is 3.82 volts and the lower limit temperature is 60 °C.

5. A circuit arrangement for performing the method according to any of the claims 1 through 4, **characterized in that** said circuit arrangement has a first threshold value switch (D) which responds when a predetermined upper limit voltage (U_{G}) is exceeded in the cell, and a second threshold value switch (C) which responds when a predetermined ambient temperature limit (T_{G}) is exceeded, and has a logic circuit (E) that connects the cell to a load (G) exclusively if the first and the second threshold value switch respond at the same time, and **in that** both the threshold value switches (C, D) are configured such that they trip, when a lower cell voltage or a lower ambient temperature is reached.

## Revendications

1. Procédé de surveillance de la sécurité de fonctionnement d'une cellule au Li rechargeable, par mesure de la tension et de la température de la cellule, **caractérisé en ce que** la cellule est déchargée jusqu'à atteindre un niveau plus bas de tension prédéterminé ou une température plus basse prédéterminée de l'environnement uniquement lorsqu'une tension limite prédéterminée de cellule (U_{G}) et une température limite prédéterminée (T_{G}) de l'environnement sont dépassées.

2. Procédé selon la revendication 1, **caractérisé en ce que** la tension limite (U_{G}) est de 4,0 volts et la température limite (T_{G}) d'environ 80°C.

3. Procédé selon les revendications 1 et 2, **caractérisé en ce que** le niveau inférieur de tension est inférieur à 3,9 volts et la limite inférieure de la température de l'environnement de 70°C.

4. Procédé selon les revendications 1 et 2, **caractérisé en ce que** la tension limite inférieure est de 3,82 volts et la température limite inférieure de 60°C.

5. Circuit en vue de l'exécution du procédé selon l'une des revendications 1 à 4, **caractérisé en ce qu'**il possède un premier commutateur (D) à valeur de seuil qui se déclenche lorsqu'une tension limite supérieure prédéterminée (U_{G}) de la cellule est dépassée et un deuxième commutateur (C) à valeur de seuil qui se déclenche lorsqu'une limite prédéterminée (T_{G}) de la température de l'environnement est dépassée, ainsi qu'un circuit logique (E) qui raccorde (G) la cellule à une charge uniquement lorsque le premier et le deuxième commutateur à valeur de seuil se déclenchent simultanément et **en ce que** les deux commutateurs (C, D) à valeur de seuil sont configurés de manière à se réenclencher lorsqu'une tension de cellule plus basse ou une température de l'environnement plus basse sont atteintes.
